# EUROPÄISCHE PATENTANMELDUNG

(11) **EP 3 584 591 A1**
(43) Veröffentlichungstag der Anmeldung: **25.12.2019**
(21) Anmeldenummer: 19180466.5
(22) Anmeldetag: 17.06.2019
(51) Int. Cl.: G01R 31/08, G01R 31/02

(54) **VERFAHREN ZUM LOKALISIEREN EINES ELEKTRISCHEN KURZSCHLUSSES INNERHALB EINES MEHRERE LEITER AUFWEISENDEN DRILLLEITERS UND KURZSCHLUSSDETEKTOR HIERFÜR**

(30) Priorität: 19.06.2018 DE 102018114707
(71) Anmelder: Loewié, Chris, 34376 Immenhausen (DE); Kölling, Robert, 34260 Kaufungen (DE)
(72) Erfinder: KÖLLING, Robert, 34260 Kaufungen (DE)
(74) Vertreter: Patentanwälte Walther Hinz Bayer PartGmbB

(57) **Zusammenfassung**

Gegenstand der Erfindung ist ein Verfahren und ein Kurzschlussdetektor zum Lokalisieren eines elektrischen Kurzschlusses innerhalb eines mehrere Leiter aufweisenden Drillleiters, wobei zunächst ein Markersignal in einen ersten zu prüfenden Leiter (12a) und in einen zweiten zu prüfenden Leiter (12b) eingespeist wird, wobei das Markersignal in den zu prüfenden Leitern (12a, 12b) ein Leitungsmagnetfeld erzeugt, wobei eine Sensoreinheit (20) umfassend mindestens eine erste Spule (22) und eine zweite Spule (24) das im zu prüfenden Leiter (12a, 12b) erzeugte Leitungsmagnetfeld misst. Ein Verfahren zum Lokalisieren eines elektrischen Kurzschlusses in einem Drillleiter zuschaffen, mit dem neben dem Kurzschluss auch ein beinahe Kurzschluss zuverlässig bestimmt werden kann und mit dem der Ort des defekten Leiters exakt bestimmt werden kann wird dadurch erreicht, dass die erste Spule (22) des Sensors (20) und die zweite Spule (24) des Sensors (20) derart zueinander angeordnet werden, dass eine virtuelle Mittellinie der Wicklung (36) der ersten Spule (22) mit einer virtuellen Mittellinie der Wicklung (38) der zweiten Spule (24) fluchtet und dass die Wicklung (38) der zweiten Spule (24) gegenläufig zur Wicklung (36) der ersten Spule (22) ausgerichtet ist, insbesondere dass die Sensoreinheit (20) das durch den Kurzschluss erzeugte Kurzschlussmagnetfeld detektiert und anzeigt.

## Beschreibung

Die vorliegende Erfindung betrifft ein Verfahren zum Lokalisieren eines elektrischen Kurzschlusses innerhalb eines mehrere Leiter aufweisenden Drillleiters gemäß dem Oberbegriff des Anspruches 1 oder gemäß dem Oberbegriff des Anspruches 2, sowie einen Kurzschlussdetektor gemäß dem Oberbegriff des Anspruches 6.

Zur Herstellung von verlustarmen Wicklungen für elektrische Maschinen, Elektromotoren, Tranformatoren, Drosseln oder dergleichen, werden sogenannte Drillleiter verwendet, die in beliebig langen Strängen hergestellte werden. Ein solcher Drillleiter setzt sich aus bis zu 96 einzelnen Leitern zusammen, wobei die Leiter zu einem vorzugsweise rechteckigen Strang verseilt sind. Zwecks Isolierung der einzelnen, vorzugsweise aus Kupfer hergestellten Leiter, ist jeder Leiter für sich lackiert oder emailliert. Bei der Herstellung eines solchen Drillleiters, insbesondere beim Verseilen der einzelnen Leiter, kommt es vor, dass die Lackierung oder Emaillierung beschädigt wird mit der Folge, dass die Isolierung geschwächt, also nicht mehr ausreichend ist (nachfolgend "beinah Kurzschluss" genannt) und schlimmstenfalls kann zwischen den benachbarten Leitern ein Kurzschluss auftreten.

In der internationalen Spezifikation IEC 60851-5.3. sind verschiedene Grundprinzipien und Testverfahren beschrieben, mit denen solche Kurzschlüsse innerhalb eines Drillleiters gefunden werden können. Darüber hinaus bietet die Firma Rigon Instruments aus Turin, Italien (siehe www.rigon.it) einen Hochspannungstester an, mit dem derartige Kurzschlüsse aufgespürt werden können. Dabei werden die zu prüfenden Leiter mit Hochspannung beaufschlagt und anhand der Messwerte kann dann festgestellt werden, in welchem Abstand von der Messstelle aus betrachtet, ein Kurzschluss vorliegt. Berücksichtigt man dabei, dass auf einer Rolle etwa 150 m Drillleiter aufgerollt sind, so kann der Kurzschluss mit dieser Methoder auf einige Meter genau festgestellt werden. Zur Behebung des Kurzschlusses wird dann der Drillleiter von der Rolle abgewickelt und es werden im Bereich des aufgespürten Kurzschlusses mehrere Meter des Drillleiters herausgeschnitten. Eine Reparatur der defekten Leiter ist nicht möglich, weil die Stelle des Kurzschlusses nicht exakt genug bestimmt werden kann.

Ein weiterer Nachteil der aus dem Stand der Technik bekannten Detektoren besteht darin, dass mit diesen jeweils nur der vom Signalgeber ausgehende erste Kurzschluss festgestellt werden kann. Ob dahinter weitere Kurzschlüsse existieren, kann mit nicht ermittelt werden.

Aus der DE 17 66 172 B2 und der DE 17 91 027 B2 ist ein Verfahren zum Orten schadhafter Stellen einer elektrischen Leitung in einem Erdkabel und ein Detektor hierfür bekannt. Dieser Detektor umfasst zwei unabhängige Spulen, deren Spulenkerne parallel zueinander ausgerichtet sind und in horizontaler Querlage über das zu prüfende Erdkabel geführt werden. Dabei wird am Ende des Erdkabels ein die zu prüfenden Leiter verbindender Kondensator angebracht und während in das Erdkabel eine Wechselspannung eingespeist wird, werden die zwei Spulen in Leitungsrichtung hintereinander und in horizontaler Querlage über das Erdkabel geführt, so dass jede der beiden Spulen das durch die Wechselspannung im Erdkabel erzeugte Magnetfeld misst. Die beiden Spulenkerne sind parallel zueinander ausgerichtet und werden quer (90°) zum Erdkabel über dieses geführt, so zeigt die Änderung des Phasenwinkels eine fehlerhafte Stelle im Kabel anzeigt.

Dabei wird in der Spule die durch den Phasenwinkel erzeugte Spannung gemessen und nur die Spannungsdifferenz wird in einer Anzeige sichtbar gemacht. Hierbei misst die vordere Spule die Spannung jenseits der Schadstelle, während die hintere Spule die Spannung diesseits der Schadstelle misst, so dass der Benutzer dann weiß, dass sich die Schadstelle zwischen der ersten und der zweiten Spule befindet.

Mit dieser Methode kann zwar die Schadstelle lokalisert werden, aber es kann nicht festgestellt werden, ob im Erdkabel eine weitere Schadstelle existiert oder nicht. Um festzustellen ob der Rest des Erdkabels fehlerfrei ist muss der Detektor über das gesamte Erdkabel geführt werden.

Ein weiterer Nachteil des aus der DE 17 66 172 B2 und der DE 17 91 027 B2 bekannten Verfahrens besteht darin, dass hier nur signifikante Schadstellen, also echte Kurzschlüsse, im Erdkabel ermittelt werden können, nicht aber schadhafte Steilem zwischen zwei Leitern, bei den nur die Isolierung beschädigt ist, bei denen aber noch kein kompletter Kurzschluss vorliegt (beinah Kurzschluss).

Davon ausgehend liegt der vorliegenden Erfindung die Aufgabe zu Grunde, ein Verfahren zum Lokalisieren eines elektrischen Kurzschlusses in einem Drillleiter zuschaffen, mit dem neben dem Kurzschluss auch ein beinah Kurzschluss zuverlässig detektiert werden kann und mit dem der Ort des defekten Leiters exakt bestimmt werden kann.

Dieses Markersignal kann in einfacher Weise durch einen Impedanzwandler erzeugt und auf die zu prüfenden Leiter gelegt werden, so dass dieses Markersignal in den zu prüfenden Leitern ein Leitungsmagnetfeld aufbaut, welches in einer eine Spule aufweisenden Sensoreinheit eine Spannung erzeugt. Dabei ist es unerheblich, ob die Sensoreinheit den Drillleiter, insbesondere die beiden zu prüfenden Leiter, berührt oder eben nicht. Schließlich erzeugt das in den Leitern aufgebaute elektromagnetische Feld (nachfolgend Leitungsmagentfeld genannt) in der Spule der Sensoreinheit auch dann eine messbare Spannung, wenn die Sensoreinheit von den zu prüfenden Leitern beabstandet ist.

Wird nun die Sensoreinheit entlang des Leiters bewegt, dass heißt, in X-Richtung entlang des Leiters bewegt, so wird die durch das Leitungsmagnetfeld in der Spule erzeugte Spannung gemessen.

Aus dem Stand der Technik ist bekannt, dass an der Stelle des Kurzschlusses (an der Stelle an der sich die zu prüfenden Leiter berühren) ein signifikanter Spannungsabfall erfolgt. Folglich erzeugt das Markersignal von der Einspeisestelle bis zur Kurzschlussstelle ein erstes, vergleichsweise starkes Leitungsmagnetfeld, während das Leitungsmagnetfeld nach jeder Kurzschlussstelle deutlich schwächer wird.

Als technische Lösung dieser Aufgabe wird erfindungsgemäß ein Verfahren mit den Merkmalen des Anspruches 1 oder 2, sowie ein Kurzschlussdetektor mit den Merkmalen des Anspruches 6 vorgeschlagen. Vorteilhafte Weiterbildungen dieses Verfahrens und dieses Kurzschlussdetektors sind den jeweiligen Unteransprüchen zu entnehmen.

Ein nach dieser technischen Lehre ausgeführtes Verfahren und ein nach dieser technischen Lehre ausgebildeter Kurzschlussdetektor haben den Vorteil, dass der an der Kurzschlussstelle auftretende Kurzschlussstrom erkannt wird mit der Folge, dass hierdurch auch vergleichsweise schwache Schadstellen, sogenannte beinah Kurzschlüsse, erkannt werden.

Insbesondere wenn das Leitungsmagentfeld durch die fluchtende Anordnung der ersten und der zweiten Spule, die gegenläufig angeordneten Spulen und durch die parallele Ausrichtung der Spulen zum Leiter des Drillleiter ausgeblendet wird, ist es möglich, auch schwache Kurzschlussströme, zum Beispiel von beinah Kurzschlüssen, zu detektieren. Im Ergebnis können hierdurch sämtliche Schwachstellen (beinah Kurzschlüsse und richtige Kurzschlüsse) des Drillleiter erkannt und gegebenenfalls behoben werden mit der Folge, dass ein hoch leistungsfähiger Drillleiter ohne Kurzschlussströme entsteht.

In einer bevorzugten Ausführungsform des Verfahrens wird die Sensoreinheit entlang des Drillleiters bewegt, ohne diesen zu berühren. Hierdurch ist auch eine automatisierte und verschleißfreie Lokalisierung eines Kurzschlusses möglich, z. B. in dem der Drillleiter automatisiert unter der Sensoreinheit hinwegbewegt wird.

Der erfindungsgemäße Kurzschlussdetektor hat den Vorteil, dass dieser so leicht und klein gebaut ist, dass er von einer Person ohne großen Kraftaufwand entlang des Drillleiters bewegt werden kann, ohne dabei den Drillleiter zu berühren. Dabei detektiert die Spule das durch das Markersignal erzeugte Magnetfeld und die dabei erzeugte Spannung zeigt an, ob an der gemessenen Stelle ein Kurzschluss vorliegt oder eben nicht.

Insbesondere wenn der Kern der Spule E-förmig ausgebildet ist, wobei in einem ersten und einem zweiten Ende des Spulensteges jeweils ein erster und ein zweiter Randsteg vorgesehen sind und wobei in der Mitte des Spulensteges ein Mittelsteg vorgesehen ist kann der vergleichsweise schwache Kurzschlussstrom detektiert werden.

Vorteilhafterwweise sind sowohl der erste als auch der zweite Randsteg und der Mittelsteg orthogonal zum Spulensteg angeordnet. Zwischen dem ersten Spulensteg und dem Mittelsteg ist eine erste Wicklung vorgesehen, sodass hier eine erste Spule realisiert wird und zwischen dem Mittelsteg und dem zweiten Randsteg ist eine zweite Wicklung vorgesehen, die eine zweite Spule realisiert. Hierdurch erzeugt das durch den Kurzschlussstrom entstandene Kurzschlussmagentfeld eine Spannung in der Sensoreinheit und detektiert somit die Stelle des Kurzschlusses.

In einer bevorzugten Ausführungsform umfasst die Sensoreinheit zwei verschiedene, baugleiche elektromagnetische Spulen, deren Spulenstege miteinander fluchtend angeordnet sind, wobei die Differenzspannung beider Spulen anzeigt, ob an der betreffenden Stelle ein Kurzschluss vorliegt oder nicht.

In einer weiteren, bevorzugten Ausführungsform ist die Wicklung der zweiten Spulen gegenläufig zur Wicklung der ersten Spule angeordnet, um die Differenzspannung zwischen den beiden Spulen messen zu können. Sofern die Differenz ungefähr 0 ist, liegt kein Kurzschluss vor, erst wenn eine messbare Differenz zwischen der Spannung der ersten und der zweiten Spule angezeigt wird, liegt an der gezeigten Stelle ein Kurzschluss vor, denn aufgrund des Kurzschlusses erfolgt ein nicht unerheblicher Spannungsabfall an den zu prüfenden Leitern.

In einer bevorzugten Weiterbildung umfasst die Spule neben dem die Wicklung tragenden Spulensteg auch einen ersten und einen zweiten, jeweils orthogonal vom Spulensteg abstehenden Seitensteg, sodass ein U-förmiger Kern entsteht. Es hat sich herausgestellt, dass bei einer Spule mit einem U-förmigen Kern durch das Magnetfeld eine relativ stabile Spannung aufgebaut wird, die im Ergebnis zu einem besseren Messergebnis führt.

Insbesondere, wenn die erste Wicklung gegenläufig zur zweiten Wicklung ausgebildet ist, können die in der ersten und zweiten Spule gemessenen Spannungen zur Differenzbildung herangezogen werden.

In einer bevorzugten Weiterbildung ist die erste Wicklung gegenläufig zur zweiten Wicklung angebracht und gleichzeitig ist das Ende der ersten Wicklung mit dem Anfang der zweiten Wicklung elektrisch verbunden, sodass eine solche E-förmige Spule mit gegenläufiger Wicklung unmittelbar die Differenzspannung zwischen den beiden Einzelspulen anzeigt. Dies hat den Vorteil, dass hier auf eine Auswerteeinheit zur Bildung der Differenzspannung verzichtet werden kann.

Zeigt nun der Sensor keine oder nur eine vernachlässigbare Spannung an, so bedeutet dies, dass an dieser Stelle der beiden zu prüfenden Leiter kein Kurzschluss vorliegt. Wenn man den Sensor dann weiter entlang des Drillleiters bewegt wird und der Sensor über eine Kurzschlussstelle kommt, so wird vom Sensor eine Spannung gemessen. Bewegt man den Sensor nun soweit, dass die angezeigte Spannung ein Maximum anzeigt, so befindet sich der mittlere Teil des E-förmigen Kerns unmittelbar an der Stelle des Kurzschlusses. Somit kann mit einem solchen Kurzschlussdetektor die Stelle des Kurzschlusses zwischen zwei zu vermessenden Leitern auf den Milimeter genau lokalisiert werden.

Dabei hat es sich als vorteilhaft erwiesen, die erste und die zweite Spule, bis auf die Richtung der Wicklung baugleich auszuführen, weil hierdurch die indizierte Spannung in der ersten und der zweiten Spule gleich ist, was eine Differenzmessung vereinfacht, denn in diesem Falle hebt sich die indizierte Spannung der ersten Spule mit der indizierten Spannung der zweiten Spule auf.

In einer bevorzugten Ausführungsform ist das Markersignal als ein Wechselstromsignal mit einer Frequenz von idealerweise 3 kH bei einer Stromstärke von idealerweise 1,5 Ampere ausgebildet. Es hat sich erwiesen, dass auch bei einem Markersignal mit einer Frequenz zwischen 0,5 kH und 10 kH und einer Stromstärke zwischen 0,1 Ampere und 4 Ampere ebenfalls gute Messergebnisse erzielt werden.

In einer vorteilhaften Verwendung des Kurzschlussdetektors wird dieser mit einem Winkel von mehr als 0°, vorzugsweise 30° oder 45°, idealerweise 90°, geneigt zu den zu prüfenden Leitern an den Drillleiter gehalten. Hierdurch wird detektiert, ob in dem zu prüfenden Leiter ein Leitungsmagnetfeld vorhanden ist oder eben nicht. Bei einer parallelen Ausrichtung des Kurzschlussdetektors gegenüber dem zu prüfenden Leiter wird die durch das Leitungsmagnetfeld in der ersten und in der zweiten Spule erzeugte Spannung ausdifferenziert, so dass kein Signal ausgegeben wird. Wird aber der Kurzschlussdetrektor nicht parallel zum Leiter gehalten, das heißt wenn der Winkel größer als 0° ist, so wird die im Kurzschlussdetektor erzeugte Spannung nicht mehr vollständig ausdifferenziert und ein Signal wird ausgegeben. Wenn also ein Siganl ertönt, so weiß man, dass im zu prüfenden Leiter duch das Markersignal ein Leitunsmagnetfeld erzeugt wird und dass geschieht nur, wenn ein weiterer Kurzschluss im Drillleiter existiert. Ertönt aber trotz geneigen Anhaltens des Kurzschlussdetektors kein Signal so weiß man, dass kein Leitungsmagnetfeld existiert und man weiß dann auch, dass von dieser Stelle bis zum Ende des Drillleiters kein weiterer Kurzschluss existiert und eine weitere Untersuchung des Drillleiters ist überflüssig.

Weitere Vorteile der erfindungsgemäßen Verfahren und des erfindungsgemäßen Kurzschlussdetektors ergeben sich aus der beigefügten Zeichnung und den nachstehend beschriebenen Ausführungsformen. Ebenso können die vorstehend genannten und die noch weiter ausgeführten Merkmale erfindungsgemäß jeweils einzeln oder in beliebigen Kombinationen miteinander verwendet werden. Die erwähnten Ausführungsformen sind nicht als abschließende Aufzählung zu verstehen, sondern haben vielmehr beispielhaften Charakter. Es zeigen:
- Fig. 1: eine schematische Darstellung eine ersten Ausführungsform eines erfindungsgemäßen Kurzschlussdetektors während des Bewegens des Kurzschlussdetektors in X-Richtung entlang eines Drillleiters;
- Fig. 2: eine Prinzipskizze zum Kurzschlussdetektor gemäß Fig. 1;
- Fig. 3: eine schematische Darstellung eines Sensors des Kurzschlussdetektors gemäß Fig. 1;
- Fig. 4: eine schematische Darstellung des Kurzschlussdetektors gemäß Fig. 1 während des Bewegens des Kurzschlussdetektors in Y-Richtung entlang eines Drillleiters;
- Fig. 5: eine schematische Darstellung des Kurzschlussdetektors gemäß Fig. 1 während des Bewegens des Kurzschlussdetektors in Z-Richtung entlang eines Drillleiters.

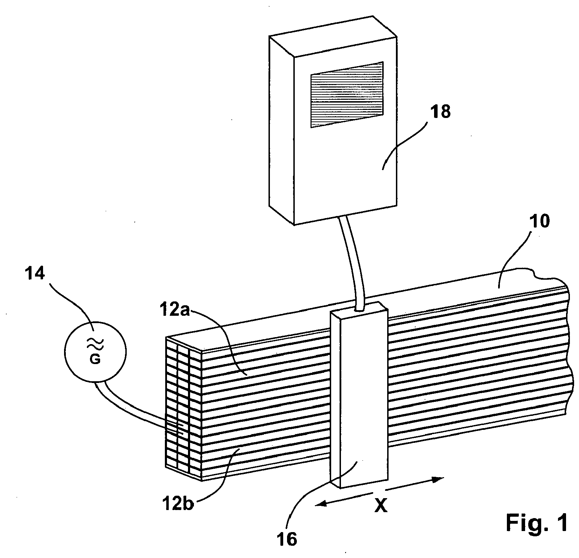

Fig. 1 zeigt in schematischer Darstellung einen Drillleiter 10 mit 45 Leitern 12a, 12b, ..., wobei jeder Leiter 12a, 12b, ... aus einem mit Kunststofflack beschichtetem Kupferstrang besteht, sodass die einzelnen Leiter 12a, 12b, ... gegeneinander isoliert sind. An den Rändern sind die einzelnen Leiter 12a, 12b, ... umgebogen (hier nicht dargestellt), das heißt verseilt, sodass die Leiter 12a, 12b, ... zusammen einen Drillleiter 10 ergeben, der zum Beispiel auf einer Rolle aufwickelbar ist. Zur Lokalisierung eines Kurzschlusses zwischen einem ersten Leiter 12a und einem zweiten Leiter 12b ist an den beiden Leitern 12a, 12b eine Signalvorrichtung 14 angeschlossen. In dieser Ausführungsform ist die Signalvorrichtung 14 ein Impedanzwandler und erzeugt in den daran angeschlossenen Leitern 12a, 12b, ... ein sinusförmiges Markersignal mit einer Wechselspannung bei einer Frequenz von 3 kHz und einem Strom von 1,5 A.

Dieses Markersignal baut in den zu prüfenden Leitern 12a, 12b ein Leitungsmagnetfeld auf, welches in einer Sensoreinheit 20 eine Spannung erzeugt. Die hier gemessene Spannung wird dann in einer Anzeigeeinheit 18 angezeigt. Dabei kann die Anzeige in optischer Form durch Signallampen oder einem an dem entsprechenden Zahlen anzeigendem Display und/oder in akustischer Form durch Ausgabe eines Tones einer bestimmten Frequenz erfolgen.

Die Sensoreinheit 20 wird beabstandet vom Drillleiter 10 in Längsrichtung des Drillleiters 10 geführt und sobald die Sensoreinheit 20 einen Kurzschluss detektiert hat, wird dieses über die Anzeigeeinheit 18 angezeigt. Dann wird die entsprechende Stelle im Drillleiter 10 vermerkt und die Sensorsoreinheit 20 wird weiter entlang des Drillleiters 10 geführt, um weitere Kurzschlüsse zu detektieren.

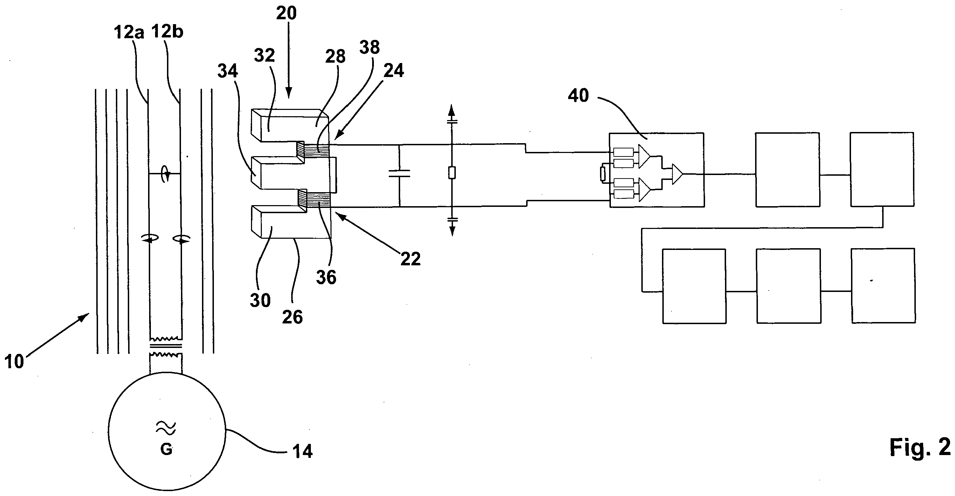

Wie insbesondere Fig. 2 zu entnehmen ist, umfasst die Sensoreinheit 20 eine erste elektromagnetische Spule 22 und eine zweite elektromagnetische Spule 24, wobei die erste Spule 22 und die zweite Spule 24 einem gemeinsamen, E-förmigen Kern 26 aus Eisen aufweisen. Dieser Kern 26 umfasst einen Spulensteg 28, an dessen ersten Ende ein orthogonal abstehemder erster Randsteg 30 ausgebildet ist und an dessen zweiten Ende ein zweiter, orthogonal abstehender Randsteg 32 ausgebildet ist, während in der Mitte des Spulensteges 28 ein orthogonal abstehender Mittelsteg 34 vorhanden ist. Der erste Randsteg 30, der zweite Randsteg 32 und der Mittelsteg 34 sind parallel zueinander ausgerichtet. Zwischen dem ersten Randsteg 30 und dem Mittelsteg 34 ist um den Spulensteg 28 herum eine erste Wicklung 36 vorgesehen, während zwischen dem Mittelsteg 34 und dem zweiten Randsteg 32 um den Spulensteg 28 herum eine zweite Wicklung 38 vorgesehen ist. Die erste Wicklung 36 ist gegenläufig zur zweiten Wicklung 38 ausgeführt, wobei das am Mittelsteg 34 befindliche Ende der ersten Wicklung 36 mit dem am Mittelsteg 34 befindlichen Anfang der zweiten Wicklung 38 verbunden ist.

Hierdurch wird die in dieser Sensoreinheit 20 auftretende Spannung zwischen den am ersten Randsteg 30 befindlichen Anfang der ersten Wicklung 36 und dem am zweiten Randsteg 32 befindlichen Ende der zweiten Wicklung 38 gemessen, wobei durch diese gegenläufige Wicklung der ersten Wicklung 36 der ersten Spule 22 gegenüber der zweiten Wicklung 38 der zweiten Spule 24 die Differenz zwischen den jeweils auftretenden Spannungen gemessen und entsprechend angezeigt wird. Dies hat den Vorteil, dass sich die an der ersten Spule 22 gemessene Spannung und die an der zweiten Spule 24 gemessenen Spannungen aufheben, solange die sich Sensoreinheit an einem Abschnitt des Drillleiters 10 befindet, in dem kein Kurzschluss vorliegt, denn beide Spulen 22, 24 vermessen dasselbe durch das Markersignal erzeugte Leitungsmagnetfeld. Gelangt die Sensoreinheit 20 an eine Stelle des Drillleiters 10, an der ein Kurzschluss vorliegt, so detektiert die Sensoreinheit 20 zusätzlich zum Leitungsmagnetfeld ein durch den Kurzschluss erzeugtes Kurzschlussmagnetfeld. Das heißt, der durch den Kurzschluss erzeugte Kurzschlussstrom wird detektiert.

Dabei wird der Effekt ausgenutzt, dass die Feldlinien im Kurzschlussmagentfeld eine andere Ausrichtung aufweisen, wie die Feldlinien des Leitungsmagentfeldes und somit zusätzlich zum Leitungsmagnetfeld eine Spannung in der Sensoreinheit 20 induzieren, sobald ein vorderer Teil der Sensoreinheit 20, insbesondere der erste Randsteg 30, die Stelle des Kurzschlusses erreicht. Besonders stark ist dieser Effekt im Bereich des Mittelsteges 34, weil dieser Mittelsteg 34 sowohl die erste Spule 22, als auch die zweite Spule 24 erreicht. Somit kann die Position des Kurzschlusses zwischen den zu messenden Leitern 12a und 12b milimetergenau bestimmt werden.

Wie insbesondere Fig. 2 zu entnehmen ist, sind der Anfang der ersten Wicklung 36 und das Ende der zweiten Wicklung 38 mit einem Verstärker 40 verbunden, der dass gemessene Signal entsprechend verstärkt und an eine Anzeigeeinheit 18 weiterleitet.

In dieser Ausführungsform die erste Spule 22 und die zweite Spule 24 baugleich ausgeführt sind, insbesondere sind die Anzahl der Wicklungen, die Stärke des Wicklungsdrahts und die Ausbildung des Kerns identisch, um, bis auf die Richtung der Wicklung, zwei identische Spulen 22, 24 zu erzielen.

In dem Bereich der zu prüfenden Leiter 12, in dem kein Kurzschluss vorliegt, erzeugt das Leitungsmagnetfeld des zu prüfenden Leiters 12a, 12b, ... in der ersten Spule 22 und in der zweiten Spule 24 eine gleich hohe Spannung. Durch die Messung der Differenz zwischen der Spannung der ersten Spule 22 und der Spannung der zweiten Spule 24 wird in diesem Falle angezeigt, dass die anliegende Spannung 0 beträgt. Es versteht sich, dass im Rahmen der Fertigungs- und Messtoleranzen kleine hiervon abweichende Zahlen ebenfalls als 0 angesehen werden.

Beim Verfahren zum Lokalisieren eines elektrischen Kurzschlusses zwischen dem ersten isolierten Leiter 12a und dem zweiten isolierten Leiter 12b des Drillleiters 10 wird die Sensoreinheit 20 derart ausgerichtet, dass der Spulensteg 28 parallel zum Leiter 12 angeordnet ist und dass sowohl der erste Randstege 30, als auch der zweite Randsteg 32 und der Mittelsteg 34 zum zu prüfenden Leiter 12a, 12b zeigen, wobei der Kern 26 der Sensoreinheit 20 wahlweise beabstandet vom Drillleiter 10, als auch direkt an den Drillleiter 10 gehalten werden kann.

Für den Fall, dass die Sensoreinheit 20 mit der ersten Spule 22 über die Stelle des Kurzschlusses hinüber gelangt ist, die zweite Spule 24 aber noch nicht, so entsteht zusätzlich der Effekt, dass in der zweiten Spule 24 eine sehr viel höhere Spannung erzeugt wird, als in der ersten Spule 22, denn aufgrund des Kurzschlusses und des damit verbundenen Leistungsabfalles hinter der Kurzschlussstelle ist das Leitungsmagentfeld hinter der Kurzschlussstelle entsprechend schwächer, sodass im Bereich hinter dem Kurzschluss im zu prüfenden Leiter 12a, 12b nur noch ein sehr viel kleineres Magnetfeld aufgebaut wird. Aufgrund der Differenzmessung in der Sensoreinheit 20 wird nun eine signifikante Spannung angezeigt, deren Maximum erreicht wird, sobald der Mittelsteg 34 exakt über der Kurschlussstelle angekommen ist. Somit kann die Position des Kurzschlusses zwischen den zu messenden Leitern 12 milimetergenau bestimmt werden.

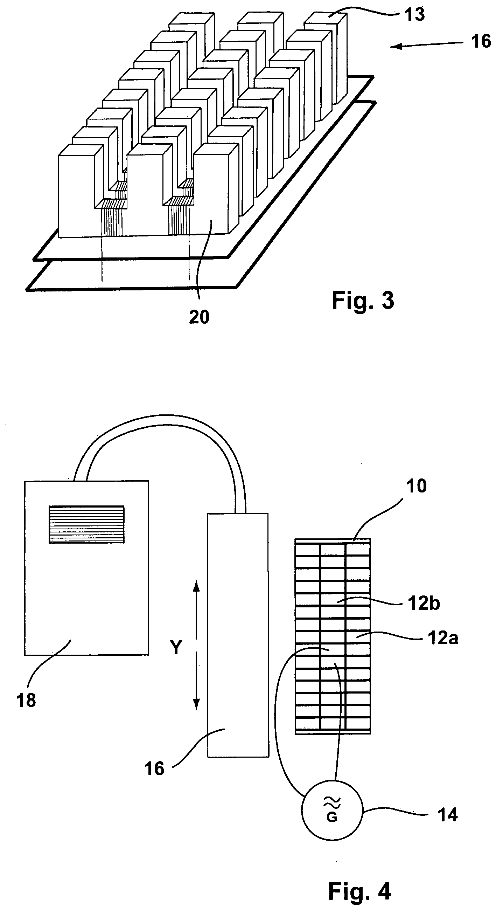

Wie insbesondere Fig. 3 zu entnehmen ist, umfasst der Sensor 16 acht nebeneinander angeordnete Sensoreinheiten 20. Dies hat den Vorteil, dass in einem Sensor 16 die gesamte Breite des Drillleiters 10 erfasst wird und somit das von den zu prüfenden Leitern 12 ausgehende Magnetfeld zuverlässig und in einfacher Weise eine entsprechende Spannung in dem nächstliegenden Sensor 16 aufbauen kann. Es versteht sich, dass die Kerne 26 der Sensoreinheit 20 in Längsrichtung zu dem jeweiligen Leiter 12 über den Drillleiter 10 geführt werden sollten, um ein optimales Messergebnis zu erzielen, dass heißt, um die Lokalisierung des Kurzschlusses in X-Richtung des Drillleiters 10 exakt bestimmen zu können.

In der Praxis ist es nun o, dsass zu Beginn der Prüfung nicht bekannt ist, welche der vielen Leiter 12a, 12b,... schadhaft sind und deshalb wird das Markersignal auf alle Leiter 12a, 12b,... gelegt. Hat man nun einen Kurzschluss detektiert, so muss noch herausgefunden werden, wo genau im Drillleiter dieser Kurschluss vorliegt, vorteilhafterweiss sollten die entsprechenden Leiter exakt ermittelt werden.

Nachdem also der Kurzschluss in X-Richtung bestimmt ist, ist es von Vorteil auch zu wissen, an welcher Stelle sich die schadhaften Leiter 12a, 12b in Y- und in Z-Richtung befinden. Erst wenn die defekten Leiter 12a, 12b in allen drei (X-, Y- und Z) Richtungen bestimmt ist, können die Fachleute beurteilen, ob eine Reparatur des defekten Leiters 12 wirtschaftlich ist oder ob das defekte Teilstück herausgetrennt werden muss.

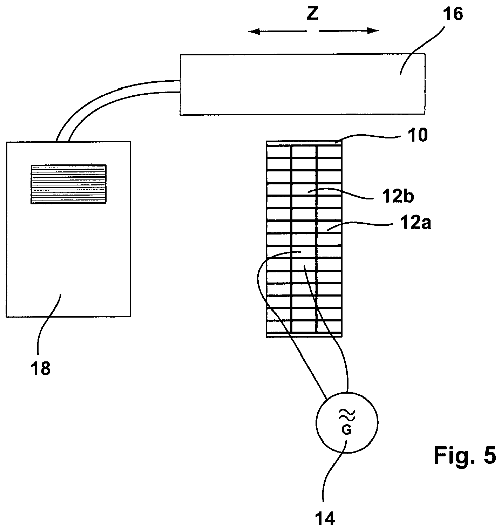

Hierzu wird der Sensor 20 an genau der Stelle des Kurzschlusses (X-Richtung) nun quer zur X-Richtung, also in Y-Richtung, bewegt, bis die Anzeige eine maximale Spannung signalisiert, wie dies in Fig. 4 dargestellt ist. Analoges geschieht in Z-Richtung, wie dies in Fig. 5 dargestellt ist. Somit kann die defekte Stelle des Leiters 12 im Raum bestimmt werden, und es kann eine Entscheidung über eine mögliche Reparatur gefällt werden.

Neben einem tatsächlichem Kurzschluss kann mit dem erfindugnsgemäßen Verfahren und dem erfidnungsgemäßen Kurzschlussdetektor auch eine Stelle im Drillleiter 10 detektiert werden, an der die Isolierung geschwächt, aber noch nicht durchbrochen ist. Bei einem solchen "beinah Kurzschluss" fließt bereits ein gewisser, wenn auch schwacher Kurzschlussstrom, der detektiert werden kann. Somit ist unter Kurzschluss im Sinne dieser Erfindung auch ein "beinah Kurzschluss" zu verstehen.

## Patentansprüche

1. Verfahren zum Lokalisieren eines elektrischen Kurzschlusses innerhalb eines mehrere Leiter aufweisenden Drillleiters,
wobei zunächst ein Markersignal in einen ersten zu prüfenden Leiter (12a) und in einen zweiten zu prüfenden Leiter (12b) eingespeist wird, wobei das Markersignal in den zu prüfenden Leitern (12a, 12b) ein Leitungsmagnetfeld erzeugt, wobei eine Sensoreinheit (20) umfassend mindestens eine erste Spule (22) und eine zweite Spule (24) das im zu prüfenden Leiter (12a, 12b) erzeugte Leitungsmagnetfeld misst, **dadurch gekennzeichnet,**
**dass** die Sensoreinheit (20) das durch den Kurzschluss erzeugte Kurzschlussmagnetfeld detektiert und anzeigt.

2. Verfahren zum Lokalisieren eines elektrischen Kurzschlusses innerhalb eines mehrere Leiter aufweisenden Drillleiters,
wobei zunächst ein Markersignal in einen ersten zu prüfenden Leiter (12a) und in einen zweiten zu prüfenden Leiter (12b) eingespeist wird, wobei das Markersignal in den zu prüfenden Leitern (12a, 12b) ein Leitungsmagnetfeld erzeugt, wobei eine Sensoreinheit (20) umfassend mindestens eine erste Spule (22) und eine zweite Spule (24) das im zu prüfenden Leiter (12a, 12b) erzeugte Leitungsmagnetfeld misst, insbesondere nach Anspruch 1,
**dadurch gekennzeichnet,**
**dass** die erste Spule (22) des Sensors (20) und die zweite Spule (24) des Sensors (20) derart zueinander angeordnet werden, dass eine virtuelle Mittellinie der Wicklung (36) der ersten Spule (22) mit einer virtuellen Mittellinie der Wicklung (38) der zweiten Spule (24) fluchtet und dass die Wicklung (38) der zweiten Spule (24) gegenläufig zur Wicklung (36) der ersten Spule (22) ausgerichtet ist,
**dass** die Sensoreinheit (20) derart parallel zu den zu prüfenden Leitern (12a, 12b) ausgerichtet wird, dass die erste Spule (22) und die zweite Spule (24) mit ihrer virtuellen Mittellinie parallel zu den zu prüfenden Leitern (12a, 12b) angeordnet sind.

3. Verfahren nach einem der vorangehenden Ansprüche,
**dadurch gekennzeichnet,**
**dass** in der ersten Spule (22) das durch das Markersignal in dem zu prüfenden Leiter (12a, 12b) erzeugte Leitungsmagnetfeld gemessen wird, wobei in der zweiten Spule (22) das durch das Markersignal in dem zu prüfenden Leiter (12a, 12b) erzeugte Leitungsmagnetfeld gemessen wird und dass aus der Differenz der gemessenen Spannungen der ersten Spule (22) und der zweiten Spule (24) eine Differenzspannung gebildet und angezeigt wird.

4. Verfahren nach einem der vorangehenden Ansprüche,
**dadurch gekennzeichnet,**
**dass** das Markersignal durch eine sinusförmige Wechselspannung mit einer Frequenz zwischen 0,5 kHz und 10 kHz, bevorzugt zwischen 2 kHz und 4 kHz, vorzugsweise von 3 kHz und eine Stromstärke zwischen 0,1 A und 4 A, bevorzugt zwischen 1 A und 2 A, vorzugsweise von 1,5 A erzeugt wird.

5. Verfahren nach einem der vorangehenden Ansprüche,
**dadurch gekennzeichnet,**
**dass** die Sensoreinheit (20) in Längsrichtung (X-Richtung) entlang des Drillleiters (10) bewegt wird, insbesondere ohne dabei den Drillleiter (10) zu berühren.

6. Kurzschlussdetektor zum Lokalisieren eines elektrischen Kurzschlusses innerhalb eines mehrere Leiter aufweisenden Drillleiters,
umfassend
eine Signalvorrichtung (14) zum Einspeisen eines Markersignales in die zu prüfenden Leiter (12a, 12b), wobei das Markersignal in der ersten zu prüfenden Leitung (12a) und in der zweiten zu prüfenden Leitung (12b) ein Leitungsmagnetfeld erzeugt,
eine Sensoreinheit (20) zur Messung des durch das Markersignal in den zu prüfenden Leitern (12a, 12b) erzeugten Leitungsmagentfeldes, wobei die Sensorenheit (20) eine erste elektromagnetische Spule (22) und eine zweite elektromagentische Spulen (24) aufweist,
**dadurch gekennzeichnet,**
**dass** die erste Spule (22) derart gegenüber der zweiten Spule (24) angeordnet ist, dass eine virtuelle Mittellinie der Wicklung (36) der ersten Spule (22) mit einer virtuellen Mittellinie der Wicklung (38) der zweiten Spule (24) fluchtet und dass die Wicklung (38) der ersten Spule (22) gegenläufig zur Wicklung (36) der zweiten Spule (24) angeordnet ist.

7. Kurzschlussdetektor nach Anspruch 6,
**dadurch gekennzeichnet,**
**dass** die Sensoreinheit (20) einen E-förmigen Kern (26) mit einem Spulensteg (28), einem ersten Randsteg (30), einem Mittelsteg (34) und einem zweiten Randsteg (32) aufweist,
**dass** am Spulensteg (28) zwischen dem ersten Randsteg (30) und dem Mittelsteg (34) eine die erste Spule (22) bildende erste Wicklung (36) vorgesehen ist, dass am Spulensteg (28) zwischen dem Mittelsteg (34) und dem zweiten Randsteg (32) eine die zweite Spule (24) bildende zweite Wicklung (38) vorgesehen ist,
wobei im Bereich des Mittelsteges (34) das Ende der ersten Wicklung (36) mit dem Anfang der zweiten Wicklung (38) verbunden ist.

8. Kurzschlussdetektor nach einem der Ansprüche 6 oder 7,
**dadurch gekennzeichnet,**
**dass** der erste Randsteg (30) an einem unterem Ende des Spulensteges (28) angeordnet ist und orthogonal von diesem absteht, dass der Mittelsteg (34) in der Mitte des Spulensteges (28) angeordnet ist und orthogonal von diesem absteht und
**dass** der zweite Randsteg (32) an einem oberen Ende des Spulensteges (28) angeordnet ist und orthogonal von diesem absteht.

9. Kurzschlussdetektor nach einem der Ansprüche 6 bis 8,
**dadurch gekennzeichnet,**
**dass** der erste Randsteg (30), der Mitteltsteg (34) und der zweite Randsteg (32) parallel zueinander ausgerichtet sind.

10. Kurzschlussdetektor nach einem der Ansprüche 6 bis 9,
**dadurch gekennzeichnet,**
**dass** die erste und die zweite Spule (22, 24), bis auf die Richtung der Wicklung (36, 38), baugleich ausgeführt sind.

11. Kurzschlussdetektor nach einem der Ansprüche 6 bis 10,
**dadurch gekennzeichnet,**
**dass** die Signalvorichtung (14) an die zu prüfenden Leiter (12) des Drillleiters (10) anschließbar ist und dass die Signalvorrichtung (14) ein Markersignal, vorzugsweise ein sinusförmiges Markersignal, erzeugt und Mittel zum Einspeisen des Markersignales in die zu prüfenden Leiter (12) aufweist, wobei das MArkersignal als Wechselstromsignal mit einer Frequenz zwischen 0,5 kHz und 10 kHz, bevorzugt zwischen 2 kHz und 4 kHz, vorzugsweise von 3 kHz ausgebildet ist und insbesondere eine Stromstärke zwischen 0,1 A und 4 A, bevorzugt zwischen 1 A und 2 A, vorzugsweise von 1,5 A aufweist.

12. Kurzschlussdetektor zum Lokalisieren eines elektrischen Kurzschlusses innerhalb eines mehrere Leiter aufweisenden Drillleiters,
umfassend
eine Signalvorrichtung (14) zum Einspeisen eines Markersignales in die zu prüfenden Leiter (12a, 12b), wobei das Markersignal in der ersten zu prüfenden Leitung (12a) und in der zweiten zu prüfenden Leitung (12b) ein Leitungsmagnetfeld erzeugt,
eine Sensoreinheit (20) zur Messung des durch das Markersignal in den zu prüfenden Leitern (12a, 12b) erzeugten Leitungsmagentfeldes, wobei die Sensorenheit (20) eine erste elektromagnetische Spule (22) und eine zweite elektromagentische Spulen (24) aufweist, **gekennzeichnet durch**
einen Sensor (16), der mindestens zwei, vorzugsweise acht, Sensoreinheiten (20) gemäß einem der Ansprüche 6 bis 11 aufweist.

13. Verwendung eines Kurzschlussdetektor zum Lokalisieren eines
elektrischen Kurzschlusses innerhalb eines mehrere Leiter aufweisenden Drillleiters gemäß einem der Ansprüche 6 bis 12, **dadurch gekennzeichnet,**
**dass** die Sensoreinheit (20) mit der ersten Spule (22) und der zweiten Spule (24) in einem Winkel größer als 0°, vorzugsweise 30°, idealerweise 90°, gegenüber dem zu prüfenden Leiter 12a, 12b des Drillleiters (10) ausgerichtet ist.
